Europäisches Patentamt

European Patent Office

Office européen des brevets

(11) Publication number: **0 061 906**
**B1**

# EUROPEAN PATENT SPECIFICATION

(45) Date of publication of patent specification: **10.06.87**

(51) Int. Cl.⁴: **C 23 C 14/48, C 23 C 8/36**

(21) Application number: **82301592.0**

(22) Date of filing: **25.03.82**

(54) **A method of, and an apparatus for, processing a workpiece with energetic particles and a product processed thereby.**

(30) Priority: 26.03.81 JP 45302/81
30.03.81 JP 47653/81

(43) Date of publication of application:
06.10.82 Bulletin 82/40

(45) Publication of the grant of the patent:
10.06.87 Bulletin 87/24

(84) Designated Contracting States:
DE FR GB IT

(56) References cited:
EP-A-0 008 634
US-A-4 108 751
US-A-4 213 844
US-A-4 250 009

J. Vac. Sci. Technol. Vol. (12), No. 4 (1975), p. 858-864

(73) Proprietor: INOUE-JAPAX RESEARCH
INCORPORATED
5289 Aza Michimasa Nagatsudamachi Midoriku
Yokohamashi Kanagawaken (JP)

(72) Inventor: Inoue, Kiyoshi
3-16-8 Kamiyoga Setagayaku
Tokyo (JP)

(74) Representative: Saunders, Harry et al
SAUNDERS & DOLLEYMORE European Patent
Attorneys 2 Norfolk Road
Rickmansworth Hertfordshire WD3 1JH (GB)

## Description

The present invention relates to a method of, and an apparatus for, processing a workpiece with energetic particles, especially energetic ions. The invention is applicable to ion plating in which energetic ions impinging on a workpiece surface are deposited thereon, ion-implantation in which energetic ions impinging upon a workpiece are diffused into the workpiece substrate and ion-etching or milling in which material of the workpiece is removed by energetic ion bombardment, all of which are generally referred to herein as energetic ion processing. The invention is also applicable to the treatment of a workpiece surface with energetic non-charged or neutral particles such as atoms or molecules, and thus should be considered to broadly relate to energetic particle processing.

During the last decades marked strides have been made in the arts of ion plating, implantation, milling and etching in an attempt to put these techniques into practical use. And yet the techniques have been finding only a limited sphere of application and have indeed left much to be desired especially as to their practical versatility.

European Patent Specification No. 0 008 634 discloses a sputtering technique in which a single substance provides both ions and neutral particles of that substance. An alloy layer may be deposited by separately energizing different metal ions from separate relevant sources.

The article J. Vac. Sci. Technol., Vol 12 No. 4 (1975) pages 858 to 864 discloses an alternating ion plating technique in which both vapour and ions of nickel are alternately deposited on a workpiece to form a layer of nickel on the workpiece.

U.S. Patent Specification No. 4,213,844 discloses ion plating apparatus in which beams of cluster ions are extracted from at least two receptacles containing different substances and caused jointly to bombard a workpiece surface.

It is a principal object of the present invention to increase the extent of practical applicability of energetic particle processing techniques, especially but not exclusively, ion processing techniques.

Another important object of the invention is to provide an energetic particle processing method whereby a new and useful material or material structure can be obtained.

A further object of the invention is to provide a novel and highly versatile apparatus for processing a workpiece with energetic particles of atomic or molecular size, which is relatively simple in structure and easy to operate.

Many other objects of the invention as well as advantages thereof will become apparent from the description which follows.

In accordance with the present invention there is provided, in a first aspect thereof, a method of processing a workpiece with energetic particles in an evacuation chamber, comprising providing a plurality of sources of said particles of predetermined different substances and arranging said sources within respective separate receptacles such that each of said receptacles is in vacuum communication with said chamber and opens towards said workpiece; forming ionised particles (ions) of at least one of said substances from the relevant source within its said receptacle; extracting said ionised particles of said one substance from the said receptacle in the form of a beam of ionised particles directed towards the workpiece; and electrically energizing said ionised particles extracted from said receptacle so that said ionised particles are propelled in said beam towards said workpiece, acquire a predetermined magnitude of kinetic energy, and bombard a selected surface area of said workpiece in said evacuation chamber, characterised by forming neutral particles of at least one other of said substances from the relevant one of said sources within its receptacle; creating a pressure gradient both to extract said neutral particles of said other substance from the said receptacle in the form of a beam of neutral particles directed towards said workpiece and to energise said neutral particles so that they are propelled in said beam, acquire a predetermined magnitude of kinetic energy, and bombard said selected surface area of said workpiece jointly with said ionised particles; said ionised particles and said neutral particles jointly bombarding said workpiece surface area constituting said energetic particles.

The invention also provides, in a second aspect thereof, an apparatus for processing a workpiece with energetic particles of atomic or molecular size by the aforementioned method, comprising: an evacuation chamber; workpiece support means disposed in said chamber; a plurality of sources of said particles of predetermined different substances, each source being held within a separate receptacle which is mounted in vacuum communication with said chamber and opens towards said workpiece; at least one ionised particle (ion) generating means associated with a selected one of said sources in a corresponding receptacle and an electrical energy supply means so connected as to produce an electrical field between the receptacle and the support means of such configuration as to extract from the receptacle said ionised particles in the form of a beam directed towards said workpiece and of such magnitude as to electrically energise said ionised particles and propel them in said beam with a predetermined magnitude of kinetic energy towards a selected surface area of said workpiece, characterised in that there is provided at least one neutral particle generating means associated with a selected one other of said sources and a pressure gradient source associated with that receptacle, the source having such a configuration as to extract said neutral particles from the receptacle in the form of a beam directed towards said workpiece, and having such a magnitude as to energise said neutral particles to propel them in said beam with a predetermined magnitude of kinetic energy towards said workpiece.

Methods and apparatus for processing a workpiece and embodying the present invention will now be described, by way of example, with reference to the accompanying diagrammatic drawings in which:

Fig. 1 is a side view diagrammatically illustrating an apparatus according to the invention in which a beam of energetic ions and a beam of energetic neutral particles are jointly applied upon a workpiece;

Fig. 2 is a side view diagrammatically illustrating another apparatus according to the invention utilizing a multiplicity of particle beam generating units;

Fig. 3 is a side view diagrammatically illustrating an ion chamber which may constitute a portion of an apparatus as shown in Fig. 1 or Fig. 2; and

Fig. 4 is a side view diagrammatically illustrating a neutral particle beam generating chamber which may constitute a portion of an apparatus as shown in Fig. 1 or Fig. 2.

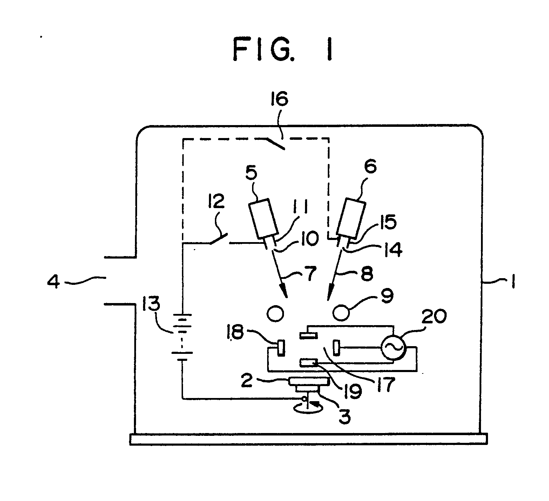

Referring first to Fig. 1, the apparatus shown includes an evacuation chamber 1 in which a workpiece 2 is securely mounted on a rotary table 3. The latter is rotatable by a motor (not shown). The chamber 1 is hermetically sealed and provided with a duct 4 which communicates with a vacuum pump (not shown) for maintaining the space in the chamber 1 at a high vacuum ranging between $10^{-6}$ and $10^{-4}$ Torr ($\approx 1.33 \times 10^{-4}$Pa and $1.33 \times 10^{-2}$Pa). The rotary table 3 is rotated to displace the workpiece 2 to subject successive surface areas thereof to impingement of energetic particles as will be described. It will be apparent that a plurality of workpieces may be carried on the rotary table 3 for successive processing.

Within the evacuation chamber 1 two heads 5 and 6 for generating a beam of particles each, are shown and are oriented towards the workpiece 2. The head 5 may radiate a beam 7 of energized ions of one substance and the head 6 may radiate a beam 8 of energized neutral particles, e.g. atoms, of another substance, the two beams impinging jointly upon the workpiece 2. A cryogenic pump 9, commonly also called cryopump, is shown provided midway between the head 6 and the workpiece 2. The cryopump 9, which may employ liquid nitrogen as its operating fluid, is used to extract the neutral particles formed in the head 6 an to focus and shape them into a beam 8 for impingement upon the workpiece 2.

The ion beam generating head 5 is provided at its outlet opening 10 with an electrode 11 connected via a switch 12 to one terminal (positive) of a voltage supply 13 whose other terminal (negative) is electrically connected to the workpiece 2 via the disk and the shaft of the rotary table 3 as shown. The voltage supply 13 has an output voltage ranging between 500 volts and 5 kilovolts sufficient to extract the ions formed in the head 5 and to accelerate and shape them into a beam 7 for impingement upon the workpiece 2.

A lens system 17 is also provided, comprising a first pair of electrodes 18 and a second pair of electrodes 19 across the paths of the beams 7 and 8 midway between the heads 5 and 6 and the workpiece 2 to focus the beams 7 and 8 into a unitary composite beam in which the energetic particles in the beam 7 and the energetic particles in the beam 8 are mixed together prior to impingement upon the workpiece 2. The first pair of the focusing electrodes 17 are juxtaposed with each other in a given direction whereas the other pair of focusing electrodes 18 are juxtaposed with each other in a horizontal direction orthogonal to that direction. The electrodes 18 and the electrodes 19 are both energized by a high-frequency AC voltage source 20. It will be apparent that any other beam-focusing lens system may be employed such as an electromagnetic coil arranged to surround the paths of the beams 7 and 8 and energized by the high-frequency AC voltage source 20.

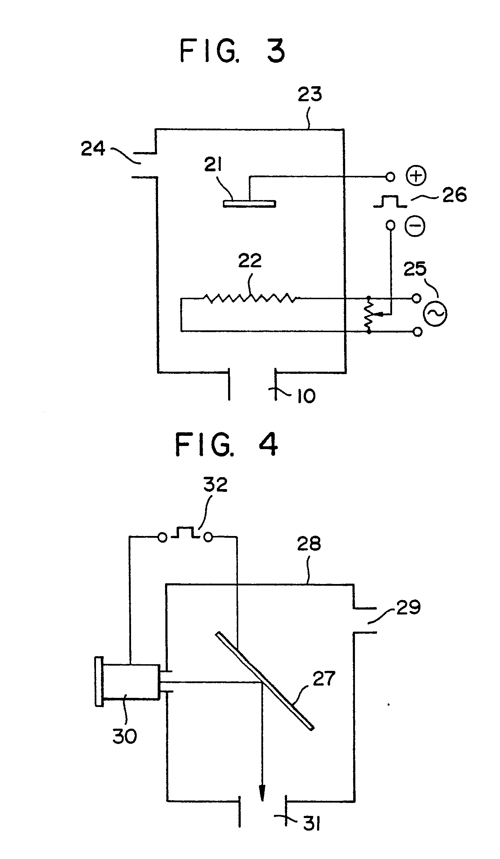

The head 5 for generating ions (and the head 6 when so arranged) may, as shown in Fig. 3, comprise an anode 21 which constitutes a source of the ions. The anode 21 is spacedly juxtaposed with a cathode filament 22 with an evacuated receptacle 23. The latter has a duct 24 which communicates with a vacuum pump or a fluid supply (not shown) to maintain the space within the receptacle 23 at a pressure ranging between $10^{-3}$ and 10 Torr ($\approx 0.1333$ Pa and 1333 Pa). The cathode filament 22 is heated by an AC supply 25 and also connected to the negative terminal of a DC voltage supply 26 whose positive terminal is connected to the anode 21. The DC voltage supply 26 is used to produce an electrical discharge between the anode 21 and the cathode 22, thereby producing ions from the anode 21. The voltage supply 26 should preferably be designed to provide a pulsed voltage or a succession of voltage pulses. The pulse duration of the voltage pulses should preferably range between 0.5 and 10 microseconds. By employing the discharge voltage in the form of a pulse, a cluster of ions is produced and, when the pulse duration is so dimensioned, contains ions therein ranging between 100 and 1000 in number. It will be apparent that the source of ions may alternatively be constituted by a gas which is introduced into the receptacle 23 through the inlet duct 24. The gas should then be composed, of course, of a predetermined substance of which are desired the ions for processing the workpiece 2. The ions formed within the receptacle 23 are withdrawn therefrom through the outlet opening 10 and shaped into a beam 7 as shown in Fig. 1.

Fig. 4 shows an embodiment of the head 6 as constructed to form neutral particles of a desired substance. This embodiment employs a source of the particles shown in the form of a plate 27 placed within a receptacle 28. The latter is formed with a duct 29 which communicates with a vacuum pump or fluid supply (not shown) to maintain the space within the receptacle 28 at a pressure ranging between $10^{-6}$ and $10^{-2}$ Torr ($\approx 1.33 \times 10^{-4}$ Pa and 1.33 Pa). A source 30 of an energy beam is constituted by an ion gun which projects an ion beam into the receptacle 28 to apply it upon the plate 27, thereby evaporating or knocking out atoms constituting the plate 27. The latter is positioned to direct the atoms liberated from the plate 27 towards the workpiece 2 through an outlet opening 31 of the receptacle 28. The ion acceleration voltage ranging between 1 and 5 kilovolts and applied from a voltage supply 32 between the gun 30 and the plate 27 should preferably be pulsed or in the form of voltage pulses. Here again, the pulse duration should preferably range between 0.5 and 10 microseconds. By employing the acceleration voltage in the form of a pulse, a cluster of neutral particles is produced and, when the pulse duration is so dimensioned, contains neutral particles therein ranging between 100 and 1000 in number. An isentropic expansion and overcooling process is applied by means of the ion-bombardment receptacle 28 and the cryopump 9 to produce a sufficiently thin cluster of neutral particles directed towards the workpiece 2 for impingement thereon.

It will be apparent that the heads 5 and 6 need not be disposed within the evacuation chamber 1 and may instead be arranged outside thereof. It is only necessary that the receptacles 23 and 28 communicate with the chamber 1 through the outlets 10 and 31, respectively.

The ion beam and the neutral particle beam are simultaneously or alternately applied to the workpiece 2. The ion beam 7 is projected from the head 5 to propel in a high vacuum of $10^{-6}$ to $10^{-4}$ Torr ($\approx 1.33 \times 10^{-4}$ Pa and $1.33 \times 10^{-2}$ Pa) within the chamber 1 for impingement upon the workpiece 2. The impact energy of the ion beam 7 impinging on the workpiece 2 is controlled by the acceleration voltage applied by the voltage source 13. To form a succession of clusters of ions, the power supply 26 provides a pulsed voltage. The number of ions in each cluster may be preset by presetting the pulse duration of the pulsed voltage furnished by the voltage supply 26. The pulse duration may range between 0.5 and 10 microseconds to provide a cluster having ions grouped therein ranging between 100 and 1000 in number. An acceleration voltage ranging between 500 and 5000 volts is applied to a cluster of ions 7 to cause them to impinge upon the workpiece 2. A cluster of ions may also be produced by turning on and off the switch 16 connecting the acceleration voltage supply 13 to the electrode 11.

The neutral particle beam 8 may be applied, simultaneously or alternately with the ion beam 7, to the workpiece 2. Within the head 6, the source plate 27 is bombarded with an energy beam of ions from the gun 30 and is thereby evaporated to furnish the neutral particles. A cluster of the neutral particles is obtained by pulsing the output voltage of the supply 32. An isentropic expansion and overcooling process is then applied. The number of neutral particles is regulated by adjusting the pulse duration of the pulsed acceleration voltage applied by the voltage supply 32 across the gun 30 and the evaporation source 27. The ion gun may be replaced by a laser beam gun. A cluster of neutral particles which develops pulsively is projected pulsively into the evacuation chamber 1 from the head 6. The ion beam 7, either continuous or clustered, is, while being accelerated, focused by the lens system 17 for impingement upon the workpiece 2. The neutral particle beam 8, either continuous or clustered, is accelerated and focused by the cryopump 9 for impingement upon the workpiece 2. The ions in the beam 7 impinge upon the workpiece 2 with a predetermined magnitude of kinetic energy preset by the acceleration voltage source 13. The neutral particles in the beam 8 impinge upon the workpiece 2 with a predetermined magnitude of kineric energy derived from their rate of projection from the head 6 and preset by the cryopump 9. The proportion in number of ions and neutral particles impinging upon the workpiece 2 continuously, or synchronously in a cluster or nonsynchronously in clusters is regulated by adjusting the voltage supply 26 and the voltage supply 32. The mass to charge ratio of the composite energetic particles can likewise be preset.

With the arrangement of the invention, an extremely unique result is obtained. For example, the plate 27 in the head 6 may be composed of a metal which is desired to be deposited upon the workpiece 2. The head 5 may furnish ions of a material which it is desirable to chemically combine with the metal. The metal ions in the beam 7 and the reactant neutral particles in the beam 8 are directed in the arrangement shown to impinge jointly on the workpiece 2 and are then allowed, through their mutual interaction, to exchange electrical energy and to chemically react. Simultaneously, a physical impact pressure is brought about to facilitate diffusion of materials of the plated layer into the substrate of the workpiece 2 while improving the density of the plated layer and its strength of adhesion to the substrate. Thus, a nitrided, carbided, fluorided or sulfided layer of deposition of an excellent quality and high hardness and/or corrosion resistance is obtainable.

The energetic particles impinging in succession hold the workpiece surface in a highly activated state. In addition, a slight portion of neutral particles will, as a result of collision with energetic ions, be ionized to facilitate growth of the plated layer and increase of its thickness and to enhance the rate of deposition. As has been pointed out, it is desirable to cluster ions and neutral particles of desired substances. The neutral particles when clustered can readily be accelerated with energetic ions under a high potential electric field. An increase in the rate of deposition and an enhancement of the properties of the plating film are obtainable in this manner.

Ion plating or deposition exploits a beam of energetic ions having kinetic energy ranging between 1 and 1000 eV. The kinetic energy may be increased to a range of $10^4$ to $10^6$ eV to allow ion implantation.

The process according to the invention is applicable to ion etching or milling as well. For example, a glass plate may be etched with a beam of oxygen ions energized at 1 keV. A beam of fluorine neutral particles is added to achieve a rate of etching as high as 400 angstroms/min (40 nm/min). The glass surface having cracks of 50 to 100 angstroms (5 to 10 nm) in depth is processed for a period of 25 seconds to remove the cracks. The strength of glass is increased to more than 200 kg/cm (kgf/cm$^2$), approximately 10 times stronger than the unprocessed glass plate.

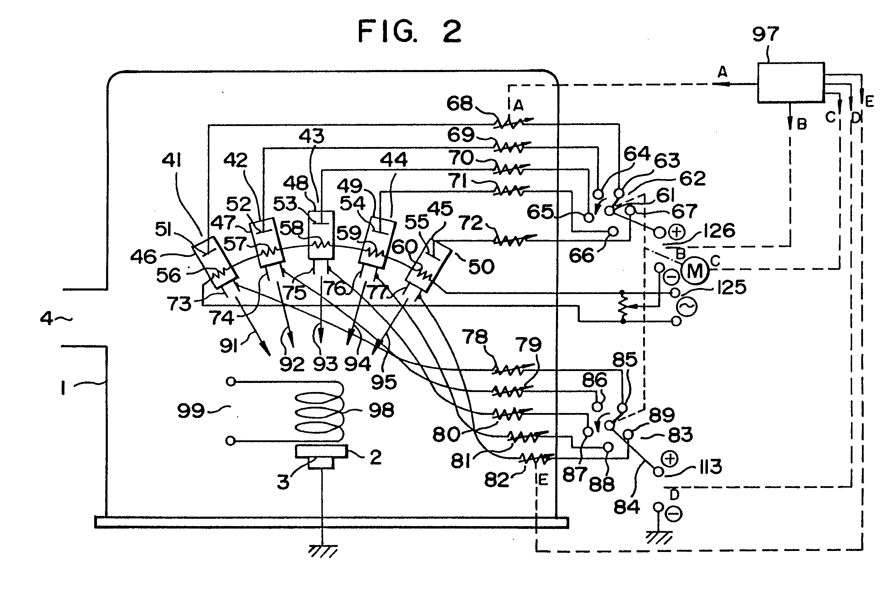

In Fig. 2, in which same reference numerals as in Fig. 1 are used to designate essentially same components, five energetic particle beam generating units 41, 42, 43, 44 and 45 are shown as disposed within the evacuation chamber 1 and as oriented towards a workpiece 2 supported on a work holder 3 which may again be a rotary table. All units 41—45 are shown for convenience as ion beam generators but a selected one of the units 41—45 is replaced by a neutral particle generator as shown in Figs. 1 and 4. As already indicated the units need not be disposed within the chamber 1, but may instead be arranged outside thereof.

Each unit 41, 42, 43, 44, 45 which is not replaced by a neutral particle generator comprises a receptacle 46, 47, 48, 49, 50 in which an anode 51, 52, 53, 54, 55 and a filament cathode 56, 57, 58, 59, 60 are spacedly juxtaposed with each other as already described. The anodes 51—55 may provide the respective sources of different substances of which are desired ions as described earlier. The cathodes 56—60 are heated by a common AC supply 125 and are also connected to the negative terminal of a common DC voltage supply 126 whose positive terminal is connected to a rotary contact 61 of a rotary switch 62. The latter has five fixed contacts 63, 64, 65, 66 and 67 which are connected to the anodes 51, 52, 53, 54 and 55 via resistors 68, 69, 70, 71 and 72, respectively. As the rotary contact 61 turns to engage with the fixed contacts 63—67 successively, the anodes and cathodes 51 and 56, 52 and 57, 53 and 58, 54 and 59 and 55 and 60 are energized successively. When the anode and the cathode in each generator 41, 42, 43, 44, 45 are energized, an electrical discharge develops between them. The anode is bombarded with electrons emitted from the cathode to liberate positive ions of the anode substance within each receptacle 46, 47, 48, 49, 50. The anodes 51—55 are composed of preselected different substances; ions of these different substances are formed in the receptacles 46—50 in a predetermined time sequence as the rotary switch 62 rotates. The resistors 68—72 are adjustably preset to variably set up the respective ion-forming voltages across the anode and the cathode in the respective receptacles 46—50. In conjunction with the rate at which the rotary switch 62 rotates to bring in the successive switching positions 63—67, these voltages thus determine the quantity (number) of ions and the quantity (number) of charges produced in each receptacle 51, 52, 53, 54, 55. Furthermore, the voltage supply 126 may furnish a pulsed voltage or a succession of voltage pulses with a pulse duration between 0.5 and 10 microseconds so that while the rotary contact 61 is in engagement with each fixed contact 63, 64, 65, 66, 67, the ions are obtained in the form of a succession of ion clusters each having ions ranging in number between 100 and 1000 within each corresponding receptacle, the clusters being successively extracted therefrom for successive impingement upon the workpiece 2. The space within each of the receptacles 51—55 is held at a reduced pressure of $10^{-3}$ to 10 Torr ($\approx$0.133 to 1333 Pa) as previously mentioned while the space within the processing chamber 1 is held at a further reduced pressure of $10^{-6}$ to $10^{-4}$ Torr ($\approx$1.33$\times$10$^{-4}$ to 1.33$\times$10$^{-2}$ Pa).

Ions, either continuous or clustered, which are formed within each of the receptacles 51—55 are extracted therefrom and accelerated by a voltage drop applied between an anodic electrode 73, 74, 75, 76, 77 provided at the receptacle outlet opening and the workpiece 2 which is grounded. The anodic electrodes 73—77 associated with the respective ion generating units 41—45 are connected via respective resistors 78, 79, 80, 81 and 82 and a rotary switch 83 to one terminal of a common DC supply 113 whose other terminal is grounded. The rotary switch 83 has a rotary contact 84 adapted to engage with five fixed contacts 85, 86, 87, 88 and 89 successively which lead via the resistors 78—82 to the ion acceleration electrodes 73—77, respectively. The rotary switch 83 is ganged with the rotary switch 62 so that when the rotary contact 61 engages with the fixed contacts 63—67, the rotary contact 84 is simultaneously brought into engagement with the fixed contacts 85—89, respectively. In this manner, the formation of ions in each receptacle or unit is synchronized with the extraction of those formed ions therefrom and the acceleration of the extracted ions. It follows therefore that beams 91, 92, 93, 94 and 95 of energetic ions of different substances are successively provided and impinge successively on the workpiece 2. The resistors 78—81 are adjustably preset to variably set up the respective acceleration voltages acting on beams of ions 91—95 of different substances and hence the respective magnitudes of kinetic energy of the ions in the respective beams 91—95.

The rotors 61 and 84 in the rotary switches 62 and 83 are driven synchronously by a motor 96 which is in turn operated by drive control signal furnished from a command circuit 97. The command circuit 97 establish time durations in which each of the rotary contacts 61 and 84 is held in engagement with the fixed contacts 63—67; 85—89, respectively, and time durations in which each of them is held out of engagement midway between one fixed contact and the next, hence determining the time durations in which the respective beams 91—95 of ions of difference substances are held to impinge the workpiece 2 and the time durations between these successive impingements. The command circuit 97 may have further control settings to act on the variable resistors 68—72, the variable resistors 78—82, the ion-forming voltage supply 126 and the acceleration voltage supply 113. Thus, the respective numbers of different ions in respective beams 91—95, their respective total electrical charges, the respective magnitudes of kinetic energy or impact energy of ions in the respective beams 91—95 and the respective numbers of different ions in each cluster in the respective beams and their respective total electrical charges may also be preprogrammed in the command circuit 97.

It will be apparent that the synchronous switches 62 and 83 may be modified to permit two or more beams of different ions 91—95 to be generated and accelerated simultaneously. A focusing electromagnetic coil 98 energized by a power supply 99 or any other lens system may then be arranged so as to focus such beams into a unitary composite beam in which different ions in these parallel produced beams are mixed together prior to impingement upon the workpiece 2. It will also be apparent that more than one of the units 41—45 may be replaced by a neutral particle generator to provide more than one beam of neutral particles and may embody the structure and function as described previously in connection with Fig. 4.

Each source of ions in each receptacle 46—50 may, other than a solid body (anode) 51—55, be a gas or metal vapour introduced into the receptacle from a suitable exterior supply through the inlet duct not shown. The gas or metal vapour introduced is subjected to electrical discharge between the anode and cathode and thereby ionized. The formation of desirable ions may also make use of an electron beam of a DC or high-frequency ionization process.

Various choices of ion source substances are possible. For example, one of ion generating units 41—45 may include a source of ions of a metal with which the workpiece is to be plated and another ion generating unit may include a source of ions of a diffusible substance such as carbon, nitrogen, boron or sulfur. The system may then be arranged to operate to allow the workpiece 2 to be bombarded with a beam of the metal ions and sequentially thereafter with a beam of energetic ions of the diffusible substance so that a carbonized, nitrided, boronided or sulfurized metal deposition layer is obtained on the workpiece surface. A plurality of beams of ions of different metals or other substances may be sequentially applied to the workpiece 2 to provide a coating consisting of stacked layers of different materials thereon. It is also possible to cyclically apply a set of beams of ions of different substance in a preselected sequence on a workpiece 2 to provide thereon a "mix" plating. Then two or more different beams may be applied synchronously. Advantageously, the arrangement of the invention allow practically any combination of different substances. Possible ion source substances include carbon, nitrogen, oxygen, argon, boron, tungsten, tantalum, nickel, chromium, titanium, aluminium, yttrium, hafnium, zirconium, niobium, vanadium and so forth. The number of ions in each beam of a particular substance as well as their kinetic energy and hence their impact energy on the workpiece are readily adjusted to provide an ion-plated, ion-implanted, ion-etched or ion-milled layer as desired on a workpiece. It has been found that by properly choosing the numbers of impinging ions, their magnitudes of impact energy on a workpiece and respective durations of beam radiations, the bombarded surface of the workpiece is crystallographically modified as desired.

**Claims**

1. A method of processing a workpiece (2) with energetic particles in an evacuation chamber (1), comprising
   providing a plurality of sources (21, 27) of said particles of predetermined different substances and arranging said sources within respective separate receptacles (23, 28) such that each of said receptacles is in vacuum communication with said chamber and opens towards said workpiece;
   forming ionised particles (ions) of at least one of said substances from the relevant source (21) within its said receptacle (23);
   extracting said ionised particles of said one substance from the said receptacle (23) in the form of a beam (7) of ionised particles directed towards the workpiece (2); and
   electrically energizing said ionised particles extracted from said receptacle (23) so that said ionised particles are propelled in said beam (7) towards said workpiece, acquire a predetermined magnitude of kinetic energy, and bombard a selected surface area of said workpiece in said evacuation chamber, characterised by

— forming neutral particles of at least one other of said substances from the relevant one of said sources (27) within its receptacle (28);
— creating a pressure gradient both to extract said neutral particles of said other substance from the said receptacle (28) in the form of a beam (8) of neutral particles directed towards said workpiece (2); and to energise said neutral particles so that they are propelled in said beam (8), acquire a predetermined magnitude of kinetic energy, and bombard said selected surface area of said workpiece (2) jointly with said ionised particles;

said ionised particles and said neutral particles jointly bombarding said workpiece surface area constituting said energetic particles.

2. A method of processing a workpiece (2) according to Claim 1 characterised by the steps of
   forming ionised particles of further different substances from the corresponding sources within the respective receptacles;
   extracting said ionised particles of the respective further substances respectively from the corresponding receptacles in the form of respective further separate beams of particles of said different substances directed towards the workpiece (2); and

electrically energizing said ionised particles from each of said receptacles independently of those from the other or others of said receptacles so that said ionised particles of the respective further different substances are propelled in said respective separate beams acquire respective predetermined magnitudes of kinetic energy, and jointly bombard a selected surface area of said workpiece (2) in said evacuation chamber (1).

3. A method according to Claim 1 or Claim 2, wherein said pressure gradient is created by applying a vacuum to the neutral particles with a gas pressure that is lower than that prevailing at said receptacle (28, 50) holding the source (27, 55) of said neutral particles, said vacuum being applied at a position intermediate said source and said workpiece surface.

4. A method according to any preceding claim, wherein said energetic particles in at least one of said beams (7, 8, 91—95) are continuously extracted from the corresponding receptacle to continuously impinge upon said workpiece.

5. A method according to any preceding claim, further comprising focusing said beams to form a unitary beam in which the energetic particles of the different substances are mixed prior to impingement upon said workpiece.

6. A method according to Claim 5, further comprising controlling the proportion of said energetic ions to said energetic neutral particles in said unitary beam.

7. A method according to any preceding claim, further comprising displacing said workpiece within said vacuum chamber to subject successive surface areas thereof to impingement of said unitary beam.

8. A method according to any preceding claim, further comprising pulsing at least one of said beams with a predetermined time duration to form a cluster of the corresponding energetic particles and bombarding said workpiece with said particles in the cluster.

9. A method according to Claim 8, wherein said time duration ranges between 0.5 and 10 microseconds to form the cluster having said energetic particles grouped therein ranging between 100 and 1000 in number.

10. A method according to Claim 8, wherein said pulsed beam is pulsed intermittently to form a succession of clusters of the individual energetic particles for successive impingement upon said workpiece.

11. A method according to Claim 10, further comprising focusing said beams (7, 8) of ionised and neutral particles respectively to form a unitary beam to mix said ions in one said beam and said neutral particles in a second said beam together prior to impingement upon said workpiece and pulsing one of the two beams repetitively with said pulse duration.

12. A method according to Claim 11, further comprising controlling the mass to charge ratio of said energetic particles impinging upon said particles at least in part by controlling said pulse duration.

13. A method according to Claim 10, wherein two beams are pulsed out of phase with one another so as to produce a first cluster of the energetic particles of a first substance and a second cluster of the energetic particles of a second substance alternately for alternate impingement upon said workpiece.

14. A method according to Claim 13, wherein the energetic particles in said first and second clusters are ions of the first and second substances, respectively.

15. A method according to Claim 13, wherein the energetic particles in said first cluster are ions of the first substance and the energetic particles in said second cluster are neutral particles of the second substance.

16. A method according to Claim 13, further comprising controlling the time durations of pulsing said two beams respectively to control the ratio of the numbers of the energetic particles in said first and second clusters impinging upon said workpiece for a given time period.

17. A method according to Claim 16, wherein each of said time durations ranges between 0.5 and 10 microseconds.

18. A method according to Claim 10, wherein two beams are recurrently pulsed substantially synchronously with one another to produce a first cluster of the energetic particles constituted by ions of a first substance and a second cluster of the energetic particles constituted by neutral particles of a second substance respectively for substantially synchronous impingement upon said workpiece.

19. A method according to Claim 18, further comprising focusing said two beams of ionised and neutral particles respectively to mix said energetic ions in said first cluster and said neutral particles in said second cluster together to form a unitary composite cluster thereof prior to impingement upon said workpiece.

20. A method according to Claim 19, further comprising controlling the mass to charge ratio of said unitary composite cluster.

21. A method according to Claim 18, wherein said two beams are pulsed with the pulse duration ranging between 0.5 and 10 microseconds.

22. A method according to Claim 8 or 9, wherein said energetic ions in one said beam are extracted from said receptacle by applying an acceleration voltage ranging between 500 volts and 5 kilovolts recurrently pulsed with a pulse duration of 0.5 to 10 microseconds to form a succession of such clusters of said ions for successive impingement upon said workpiece, and further comprising controlling the impact energy of each of said successive clusters impinging on said workpiece by controlling said acceleration voltage.

23. A method according to any preceding claim, wherein said neutral particles are formed within the relevant receptacle (28) by impinging an energy beam on the relevant source (27) held therein so as to knock out atoms thereof for constituting said neutral particles.

24. A method according to Claim 23, wherein the pressure gradient which causes said neutral particles to be extracted from the relevant receptacle and to acquire said corresponding magnitude of kinetic energy is created by vacuum pumping said chamber (1) at a position (9) intermediate the source of neutral particles and said workpiece so as to induce a gas pressure lower than that at said receptacle (28), and further comprising controlling said kinetic energy of said neutral particles by varying the said gas pressure.

25. A method according to Claim 23 or Claim 24, further comprising recurrently pulsing said beam of neutral particles by pulsing said energy beam impinging on said relevant source (27).

26. A method according to any preceding claim, further comprising maintaining the receptacle with said source of ions, the receptacle with said source of neutral particles and said evacuation chamber at pressures of $10^{-3}$ to 10 Torr, $10^{-6}$ to $10^{-2}$ Torr and $10^{-6}$ to $10^{-4}$ Torr (0.1333 to 1333 Pa, $1.333 \times 10^{-4}$ to 1.333 Pa, and $1.333 \times 10^{-4}$ to $1.333 \times 10^{-2}$ Pa), respectively.

27. A method according to Claim 4 wherein the continuously extracted and impinging beam is of neutral particles and comprising forming, extracting, directing and energising particles of different substances to form a plurality of beams of energetic particles constituted by ions of different substances, for bombarding jointly said surface area.

28. A method according to Claim 27, further comprising sequentially producing said beams of energetic particles of different substances to bombard said workpiece successively therewith.

29. A method according to Claim 28, wherein the impact energies of said energetic particles impinging on said workpiece successively with said sequentially produced beams are set at respective predetermined magnitudes.

30. A method according to Claim 29, further comprising maintaining each of said sequentially produced beams of said energetic particles impinging on said workpiece for a time duration predetermined in conjunction with a predetermined crystallographic modification desired in the bombarded surface area of the workpiece.

31. A method according to any one of the Claims 28 to 30, wherein the different beams are sequentially produced by sequentially forming said particles of different substances from the corresponding sources in the respective receptacles.

32. A method according to any one of the Claims 28 to 30, wherein the different beams are sequentially produced by sequentially extracting and energizing said particles formed in the respective receptacles.

33. A method according to any one of the Claims 28 to 32, wherein said workpiece is bombarded with energetic particles constituted by ions of different substances to sequentially deposit said substances successively on said workpiece.

34. A method according to Claim 27, further comprising focusing said beams of energetic ions of different substances prior to impingement upon said workpiece to form a composite beam of said ions mixed together for deposition upon said workpiece.

35. A method according to Claim 27, further comprising focusing said beams of energetic ions of different substances prior to arrival on said workpiece to form a composite beam of ions mixed together for kinetic diffusion into said workpiece.

36. An apparatus for processing a workpiece (2) with energetic particles of atomic or molecular size by a method according to any one of the Claims 1 to 35, comprising:

an evacuation chamber (1);

workpiece support means (3) disposed in said chamber (1);

a plurality of sources (21, 27) of said particles of predetermined different substances, each source being held within a separate receptacle (23, 28) which is mounted in vacuum communication with said chamber (1) and opens towards said workpiece (2);

at least one ionised particle (ion) generating means (5, 22, 25, 26) associated with a selected one of said sources (21) in a corresponding receptacle (23); and

an electrical energy supply means (10, 12, 13) so connected as to produce an electrical field between the receptacle (23) and the support means (3) of such configuration as to extract from the receptacle said ionised particles in the form of a beam (7) directed towards said workpiece (2) and of such magnitude as to electrically energise said ionised particles and propel them in said beam with a predetermined magnitude of kinetic energy towards a selected surface area of said workpiece (2);

characterised in that there is provided

— at least one neutral particle generating means (6, 27, 30, 32) associated with a selected one other (27) of said sources; and
— a pressure gradient source (9) associated with that receptacle the source having such a configuration as to extract said neutral particles from the receptacle in the form of a beam (8) directed towards said workpiece and having such a magnitude as to energise said neutral particles to propel them in said beam (8) with a predetermined magnitude of kinetic energy towards said workpiece (2).

37. An apparatus according to Claim 36 characterised by further ionised particle (ion) generating means associated with said sources respectively in corresponding receptacles; and

a plurality of further electrical energy supply means associated with said receptacles respectively the further supply means having such configurations as to extract said ionised particles of the respective different substances in the form of respective particle beams directed towards said workpiece (2) and being of such magnitude as to electrically energize said ionised particles in said respective beams to propel them with respective predetermined magnitudes of kinetic energy towards said workpiece for joint bombardment of a selected surface area of the workpiece thereby.

38. Apparatus according to Claim 36 or 37, wherein said energy supply means (9) comprises a vacuum pumping means (9) positioned to vacuum pump said chamber (1) at a location intermediate said workpiece (2) and said source of neutral particles, the vacuum produced being of such magnitude that the gas pressure at the workpiece is lower than that prevailing adjacent said receptacle (28, 50) in which said neutral particles are formed, and of such magnitude as to entrain and accelerate said neutral particles in said beam.

39. An apparatus according to any one of the Claims 36 to 38, wherein the or each said electrical energy supply means includes at least one voltage supply (13, 113) the voltage supply being of such magnitude and configuration as to apply an acceleration potential to ions formed by the associated ion generating means to cause them to be propelled with a said predetermined magnitude of kinetic energy and to impinge upon said workpiece.

40. An apparatus according to any one of the Claims 36 to 39, further comprising switching means (12, 16, 83) for pulsing the or each said beam of ions to form a cluster of ions.

41. An apparatus according to any one of Claims 36 to 40 including means (17—19) for focusing said beams the means being of such configuration as to form a unitary beam in which the energetic particles of the different substances are mixed prior to their impingement upon said workpiece.

42. An apparatus according to Claim 41 including variable control means variable to control the proportion of the energetic particles from the individual beams in the unitary beam.

43. An apparatus according to any of Claims 36 to 42 including means for displacing said workpiece within said evacuation chamber to subject successive surface areas thereof to impingement of said beams.

44. An apparatus according to any one of Claims 36 to 43 including means (12, 16, 62, 83) conditioned to pulsing at least one of said beams with a predetermined time duration to form a cluster of the corresponding energetic particles and bombarding said workpiece with said particles in the cluster.

45. An apparatus according to Claim 44 wherein the pulsing means is conditioned to provide pulses of which the time duration ranges between 0.5 and 10 microseconds so as to form the said cluster with the number of energetic particles grouped therein ranging between 100 and 1000.

46. An apparatus according to Claim 44 or 45 wherein the pulsing means is conditioned to pulse at least one said beam intermittently to form a succession of clusters of the individual energetic particles for successive impingement upon said workpiece.

47. An apparatus according to Claim 41 or any of Claims 42 to 46 appended thereto including means for pulsing one of the beams in the said unitary beam repetitively.

48. An apparatus according to Claim 41 or any of Claims 42 to 46 appended thereto including control means for pulsing the beams out of phase with one another to produce a first cluster of the energetic particles and a second cluster of the energetic particles alternately for alternate impingement upon said workpiece.

49. An apparatus according to any one of Claims 36 to 48 including means (13, 113) for supplying an ionised particle extracting acceleration voltage ranging between 500 volts and 5 kilovolts.

50. An apparatus according to any one of Claims 36 to 49 including as said neutral particle generating means a means (30) positioned so that when energised it impinges an energy beam on said neutral particle source to knock out therefrom atoms constituting said neutral particles.

51. An apparatus according to any one of Claims 36 to 50, including a vacuum pumping means coupled to each said receptacle holding a said source of ions, said receptacle holding a said source of neutral particles, and said evacuation chamber and having operating characteristics sufficient to maintain them respectively at pressures of $10^{-3}$ to 10 Torr, $10^{-6}$ to $10^{-2}$ Torr and $10^{-6}$ to $10^{-4}$ Torr ($\approx$0.1333 to 1333 Pa, $1.333\times10^{-4}$ to 1.333 Pa, and $1.333\times10^{-4}$ to $1.333\times10^{-2}$ Pa).

**Patentansprüche**

1. Verfahren zum Bearbeiten eines Werkstücks (2) mit energiereichen Teilchen in einer Vakuumkammer (1), umfassend

Vorsehen einer Vielzahl von Quellen (21, 27) derartiger Teilchen von vorbestimmten unterschiedlichen Substanzen und Anordnen dieser Quellen in jeweiligen separaten Behältern (23, 28), so daß jeder dieser Behälter in Vakuumverbindung mit der Kammer steht und sich zu dem Werkstück hin öffnet;

Bilden von ionisierten Teilchen (Ionen) mindestens einer des Substanzen von der betreffenden Quelle (21) innerhalb ihres Behälters (23);

Ausziehen der ionisierten Teilchen der besagten einen Substanz aus dem Behälter (23) in Form eines auf das Werkstück (2) gerichteten Strahls (7) von ionisierten Teilchen; und

Beaufschwagen der aus dem Behälter (23) ausgezogenen ionisierten Teilchen mit elektrischer Energie, so daß die ionisierten Teilchen in dem Strahl (7) in Richtung des Werkstücks angetrieben werden, eine vorgegebene Menge an kinetischer Energie aufnehmen und einen ausgewählten Oberflächenbereich des Werkstücks in der Vakuumkammer beschießen,

gekennzeichnet durch

Bilden von neutralen Teilchen mindestens einer weiterer der Substanzen von der betreffenden Quelle (27) in ihrem Behälter (28);

Erzeugen eines Druckgradienten, um sowohl die neutralen Teilchen der besagten anderen Substanz aus dem Behälter (28) in Form eines auf das Werkstück (2) gerichteten Strahls (8) aus neutralen Partikeln auszuziehen als auch die neutralen Teilchen zu beaufschlagen, so daß sie in dem Strahl (8) angetrieben werden, eine vorbestimmte Menge an kinetischer Energie aufnehmen und den ausgewählten Oberflächenbereich des Werkstücks (2) gemeinsam mit den ionisierten Teilchen beschießen;

wobei die den Oberflächenbereich des Werkstücks gemeinsam beschießenden ionisierten und neutralen Teilchen die besagten energiereichen Teilchen darstellen.

2. Verfahren zum Bearbeiten eines Werkstücks (2) nach Anspruch 1, gekennzeichnet durch folgende Schritte:

Bilden von ionisierten Teilchen weiterer unterschiedlicher Substanzen aus entsprechenden Quellen innerhalb der jeweiligen Behälter;

Ausziehen der ionisierten Teilchen der jeweiligen weiteren Substanzen aus den entsprechenden Behältern in Form von jeweils weiteren, getrennten, auf das Werkstück (2) gerichteten Strahlen von Teilchen der unterschiedlichen Substanzen; und

Beaufschlagen der ionisierten Teilchen aus den Behältern mit elektrischer Energie unabhängig von denen aus dem bzw. den anderen Behälter(n), so daß die ionisierten Teilchen der jeweiligen weiteren unterschiedlichen Substanzen in den jeweiligen getrennten Strahlen angetrieben werden, jeweils vorbestimmte Mengen an kinetischer Energie aufnehmen und einen ausgewählten Oberflächenbereich des Werkstücks (2) in der Vakuumkammer (1) gemeinsam beschießen.

3. Verfahren nach Anspruch 1 oder 2, wobei der Druckgradient dadurch erzeugt wird, daß an die neutralen Teilchen ein Vakuum mit einem Gasdruck angelegt wird, der kleiner ist als derjenige, der in dem die Quelle (27, 55) der neutralen Teilchen enthaltenden Behälter (28, 50) herrscht, wobei das Vakuum an einer Stelle zwischen der Quelle und der Werkstück-Oberfläche angelegt wird.

4. Verfahren nach einem der vorhergehenden Ansprüche, wobei die energiereichen Teilchen in mindestens einem der Strahlen kontinuierlich aus dem betreffenden Behälter ausgezogen werden, so daß sie kontinuierlich auf das Werkstück treffen.

5. Verfahren nach einem der vorhergehenden Ansprüche, ferner umfassend das Fokussieren der Strahlen zur Bildung eines einheitlichen Strahls, in dem die energiereichen Teilchen der verschiedenen Substanzen vor dem Auftreffen auf das Werkstück gemischt werden.

6. Verfahren nach Anspruch 5, weiterhin umfassend das Steuern der Verhältnisses zwischen den energiereichen Ionen und den energiereichen neutralen Teilchen in dem einheitlichen Strahl.

7. Verfahren nach einem der vorhergehenden Ansprüche, ferner umfassend das Verschieben des Werkstücks innerhalb der Vakuumkammer, um aufeinanderfolgende Oberflächenbereiche des Werkstücks dem Auftreffen des einheitlichen Strahls auszusetzen.

8. Verfahren nach einem der vorhergehenden Ansprüche, weiterhin umfassend den impulsförmigen Betrieb mindestens eines der Strahlen mit vorgegebener zeitlicher Dauer, um eine Anhäufung der entsprechenden energiereichen Teilchen zu bilden, und Beschießen des Werkstücks mit den Teilchen in der Anhäufung.

9. Verfahren nach Anspruch 8, wobei die zeitliche Dauer zwischen 0,5 und 10 Mikrosekunden liegt, um die Anhäufung so zu bilden, daß die Anzahl der darin gesammelten energiereichen Teilchen zwischen 100 und 1000 beträgt.

10. Verfahren nach Anspruch 8, wobei der impulsförmig betriebene Strahl intermittierend impulsförmig betrieben wird, um eine Aufeinanderfolge von Anhäufungen der einzelnen energiereichen Teilchen zu bilden, die nacheinander auf das Werkstück auftreffen.

11. Verfahren nach Anspruch 10, weiterhin umfassend das Fokussieren der Strahlen (7, 8) aus ionisierten bzw. neutralen Teilchen zur Bildung eines einheitlichen Strahls, um die Ionen in einem der Strahlen und die neutralen Teilchen in dem zweiten Strahl miteinander zu mischen, bevor sie auf das Werkstück auftreffen, sowie den wiederholten impulsförmigen Betrieb eines der Strahlen innerhalb der Impulsdauer.

12. Verfahren nach Anspruch 11, weiterhin umfassend das Steuern der Verhältnisses von Masse zu Ladung der auf das Werkstück auftreffenden energiereichen Teilchen mindestens teilweise durch Steuern der Impulsdauer.

13. Verfahren nach Anspruch 10, wobei die beiden Strahlen mit ungleicher Phase impulsbetrieben werden, um abwechselnd eine erste Anhäufung der energiereichen Teilchen einer ersten Substanz und eine zweite Anhäufung der energiereichen Teilchen einer zweiten Substanz zu bilden, die abwechselnd auf das Werkstück auftreffen.

14. Verfahren nach Anspruch 13, wobei die energiereichen Teilchen in der ersten und der zweiten Anhäufung Ionen der ersten bzw. der zweiten Substanz sind.

15. Verfahren nach Anspruch 13, wobei die energiereichen Teilchen in der ersten Anhäufung Ionen der ersten Substanz und die energiereichen Teilchen in der zweiten Anhäufung neutrale Teilchen der zweiten Substanz sind.

16. Verfahren nach Anspruch 13, weiterhin umfassend das Steuern der Zeitspannen des Impulsbetriebs der beiden Strahlen, um das Verhältnis der Anzahlen von in einer gegebenen Zeitspanne auf das Werkstück auftreffenden energiereichen Teilchen in der ersten und der zweiten Anhäufung zu steuern.

17. Verfahren nach Anspruch 16, wobei die Zeitspannen zwischen 0,5 und 10 Mikrosekunden liegen.

18. Verfahren nach Anspruch 10, wobei die beiden Strahlen im wesentlichen synchron wiederholt impulsbetrieben werden, um eine erste Anhäufung aus den von Ionen einer ersten Substanz gebildeten energiereichen Teilchen bzw. eine zweite Anhäufung aus den von neutralen Teilchen einer zweiten Substanz gebildeten energiereichen Teilchen zu erzeugen, die im wesentlichen gleichzeitig auf das Werkstück auftreffen.

19. Verfahren nach Anspruch 18, weiterhin umfassend das Fokussieren der beiden Strahlen von ionisierten bzw. neutralen Teilchen, um die energiereichen Ionen in der ersten Anhäufung und die neutralen Teilchen in der zweiten Anhäufung miteinander zu vermischen und vor dem Auftreffen auf das Werkstück eine einheitliche zusammengesetzte Anhäufung daraus zu bilden.

20. Verfahren nach Anspruch 19, weiterhin umfassend das Steuern des Verhältnisses von Masse zu Ladung der einheitlichen zusammengesetzten Anhäufung.

21. Verfahren nach Anspruch 18, wobei die beiden Strahlen mit einer Impulsdauer zwischen, 5 und 10 Mikrosekunden impulsbetrieben werden.

22. Verfahren nach Anspruch 8 oder 9, wobei die energiereichen Ionen in einem derartigen Strahl aus dem Behälter dadurch ausgezogen werden, daß eine Beschleunigungsspannung zwischen 500 Volt und 5 Kilovolt in weiderholtem Impulsbetrieb mit einer Impulsdauer von 0,5 bis 10 Mikrosekunden angelegt wird, um eine Folge derartiger Anhäufungen aus den Ionen zu bilden, die nacheinander auf das Werkstück auftreffen, und weiterhin umfassend das Steuern der Auftreffenergie jeder der auf das Werkstück auftreffenden aufeinanderfolgenden Anhäufungen durch Steuern der Beschleunigungsspannung.

23. Verfahren nach einem der vorhergehenden Ansprüche, wobei die neutralen Teilchen in dem entsprechenden Behälter (28) dadurch gebildet werden, daß ein Energiestrahl auf die betreffende Quelle (27) auftrifft, um die neutralen Teilchen bilende Atome davon herauszuschlagen.

24. Verfahren nach Anspruch 23, wobei der Druckgradient, der bewirkt, daß die neutralen Teilchen aus dem betreffenden Behälter ausgezogen werden und die entsprechende Menge an kinetischer Energie aufnehmen, durch Vakuumpumpen der Kammer (1) an einer Stelle (9) zwischen der Quelle von neutralen Teilchen und dem Werkstück erzeugt wird, um einen Gasdruck zu bewirken, der niedriger ist als der Druck in dem Behälter (28), und wobei die kinetische Energie der neutralen Teilchen durch Ändern des Gasdrucks gesteuert wird.

25. Verfahren nach Anspruch 23 oder 24, weiterhin umfassend den wiederholten Impulsbetrieb des Strahls von neutralen Teilchen durch Impulsbetrieb des auf die betreffende Quelle (27) auftreffenden Energiestrahls.

26. Verfahren nach einem der vorhergehenden Ansprüche, weiterhin umfassend das Aufrechterhalten eines Druckes von $10^{-3}$ bis 10 Torr ($\approx 0,1333$ bis 1333 Pa) in dem Behälter mit der Ionenquelle, eines Druckes von $10^{-6}$ bis $10^{-2}$ Torr ($\approx 1,333\times10^{-4}$ bis 1,333 Pa) in dem Behälter mit der Quelle neutraler Teilchen, und eines Druckes von $10^{-6}$ bis $10^{-4}$ Torr ($\approx 1,333\times10^{-4}$ bis $1,333\times10^{-2}$ Pa) in der Vakuumkammer.

27. Verfahren nach Anspruch 4, wobei der kontinuierlich ausgezogene und auftreffende Strahl aus neutralen Teilchen besteht und wobei Teilchen von unterschiedlichen Substanzen gebildet, extrahiert, gerichtet und mit Energie beaufschlagt werden, um eine Vielzahl von Strahlen von energiereichen Teilchen zum gemeinsamen Beschießen des Oberflächenbereichs zu bilden.

28. Verfahren nach Anspruch 27, weiterhin umfassend das sequentielle Erzeugen der Strahlen aus energiereichen Teilchen unterschiedlicher Substanzen, um das Werkstück nacheinander damit zu beschießen.

29. Verfahren nach Anspruch 28, wobei die Auftreffenergien der energiereichen Teilchen, die nacheinander mit den sequentiell erzeugten Strahlen auf das Werkstück auftreffen, auf jeweils vorgegebene Werte eingestellt werden.

30. Verfahren nach Anspruch 29, weiterhin umfassend das Aufrechterhalten jeder der sequentiell erzeugten, auf das Werkstück auftreffenden Strahlen der energiereichen Teilchen über eine zeitliche Dauer, die in Verbindung mit einer im dem beschossenen Oberflächenbereich des Werkstücks erwünschten vorgegebenen kristallographischen Änderung vorgegeben ist.

31. Verfahren nach einem der Ansprüche 28 bis 30, wobei die verschiedenen Strahlen sequentiell dadurch erzeugt werden, daß die Teilchen der unterschiedlichen Substanzen aus den entsprechenden Quellen in den betreffenden Behältern sequentiell gebildet werden.

32. Verfahren nach einem der Ansprüche 28 bis 30, wobei die verschiedenen Strahlen sequentiell dadurch erzeugt werden, daß die Teilchen aus den betreffenden Behältern nacheinander ausgezogen und mit Energie beaufschlagt werden.

33. Verfahren nach einem der Ansprüche 28 bis 32, wobei das Werkstück mit den von Ionen der unterschiedlichen Substanzen gebildeten energiereichen Teilchen beschossen wird, um die Substanzen nacheinander auf dem Werkstück sequentiell aufzutragen.

34. Verfahren nach Anspruch 27, weiterhin umfassend das Fokussieren der Strahlen aus energiereichen Ionen der unterschiedlichen Substanzen, bevor diese auf das Werkstück auftreffen, um aus den miteinander gemischten Ionen einen zusammengesetzten Strahl zum Auftrag auf das Werkstück zu bilden.

35. Verfahren nach Anspruch 27, weiterhin umfassend das Fokussieren der Strahlen aus energiereichen Ionen der unterschiedlichen Substanzen, bevor diese das Werkstück erreichen, um aus den miteinander gemischten Ionen einen zusammengesetzten Strahl zum kinetischen Eindiffundieren in das Werkstück zu bilden.

36. Vorrichtung zum Bearbeiten eines Werkstücks (2) mit energiereichen Teilchen atomarer oder molekularer Größe nach einem Verfahren gemäß einem der Ansprüche 1 bis 35, umfassend eine Vakuumkammer (1);

eine in der Kammer (1) angeordnete Werkstück-Halterungseinrichtung (3);

eine Vielzahl von Quellen (21, 27) derartiger Teilchen von vorgegebenen unterschiedlichen Substanzen, wobei jede Quelle in einem eigenen Behälter (23, 28) gehalten ist, der mit der Kammer (1) in Vakuumverbindung steht und sich zu dem Werkstück (2) hin öffnet;

mindestens eine einer ausgewählten Quelle (21) in einem entsprechenden Behälter (23) zugeordnete Einrichtung (5, 22, 25, 26) zur Erzeugung von ionisierten Teilchen (Ionen); und

eine elektrische Energieversorgungseinrichtung (10, 12, 13), die so angeschlossen ist, daß sie zwischen dem Behälter (23) und der Halterungseinrichtung (3) ein elektrisches Feld mit einer derartigen Konfiguration, daß die ionisierten Teilchen in Form eines auf das Werkstück (2) gerichteten Strahls (7) aus dem Behälter ausgezogen werden, und mit einer derartigen Größe erzeugt, daß die ionisierten Teilchen mit elektrischer Energie beaufschlagt und in dem Strahl mit einer vorgegebenen Menge an kinetischer Energie gegen einen ausgewählten Oberflächenbereich des Werkstücks (2) angetrieben werden;

dadurch gekennzeichnet, daß vorgesehen sind

mindestens eine einer ausgewählten anderen Quelle (27) zugeordnete Einrichtung (6, 27, 30, 32) zur Erzeugung von neutralen Teilchen; und

eine diesem Behälter zugeordnete Druckgradient-Quelle (9), die eine derartige Konfiguration aufweist, daß die neutralen Teilchen in Form eines auf das Werkstück gerichteten Strahls (8) aus dem Behälter ausgezogen werden, und eine derartige Größe, daß die neutralen Teilchen mit Energie beaufschlagt werden, um sie in dem Strahl (8) mit einer vorgegebenen Menge an kinetischer Energie gegen das Werkstück (2) anzutreiben.

37. Vorrichtung nach Anspruch 36, gekennzeichnet durch weitere den jeweiligen Quellen in den entsprechenden Behältern zugeordnete Einrichtungen zur Erzeugung von ionisierten Teilchen (Ionen); und eine Vielzahl von weiteren den Behältern jeweils zugeordneten elektrischen Energieversorgungseinrichtungen, die derartige Konfigurationen aufweisen, daß sie die ionisierten Teilchen der jeweiligen unterschiedlichen Substanzen iForm von auf das Werkstück (2) gerichteten Strahlen der jeweiligen Teilchen ausziehen, und eine derartige Größe, daß die ionisierte Teilchen mit elektrischer Energie beaufschlagt werden, um sie mit jeweils vorgegebenen Mengen an kinetischer Energie gegen das Werkstück zum gemeinsamen Beschuß eines ausgewählten Oberflächenbereichs des Werkstücks anzutreiben.

38. Vorrichtung nach Anspruch 36 oder 37, wobei die Energieversorgungseinrichtung (9) eine Vakuumpumpeinrichtung (9) umfaßt, die so angeordnet ist, daß sie die Kammer (1) an einer Stelle zwischen dem Werkstück (2) und der Quelle von neutralen Teilchen auf Vakuum pumpt, wobei das erzeugte Vakuum eine derartige Größe hat, daß der Gasdruck an dem Werkstück niedriger ist als der Druck, der neben dem Behälter (28, 50) vorherrscht, in dem die neutralen Teilchen gebildet werden, und eine solche Größe, daß die neutralen Teilchen in dem Strahl mitgerissen und beschleunigt werden.

39. Vorrichtung nach einem der Ansprüche 36 bis 38, wobei die bzw. jede elektrische Energieversorgungseinrichtung mindestens eine Spannungsversorgung (13, 113) umfaßt, die eine derartige Größe und Konfiguration aufweist, daß sie den von der zugeordneten Ionenerzeugungseinrichtung gebildeten Ionen ein Beschleunigungspotential zuführt, das bewirkt, daß diese mit einer vorgegebenen Menge an kinetischer Energie angetrieben werden und auf das Werkstück auftreffen.

40. Vorrichtung nach einem der Ansprüche 36 bis 39, weiterhin umfassend eine Schalteinrichtung (12, 16, 83) zum Impulsbetrieb des bzw. jedes Ionenstrahls zur Bildung einer Ionenanhäufung.

41. Vorrichtung nach einem der Ansprüche 36 bis 40, enthaltend eine Einrichtung (17—19) zum Fokussieren der Strahlen, wobei die Einrichtung eine solche Konfiguration hat, daß sie einen einheitlichen Strahl bildet, in dem die energiereichen Teilchen aus den unterschiedlichen Substanzen vor ihrem Auftreffen auf das Werkstück vermischt werden.

42. Vorrichtung nach Anspruch 41, umfassend eine Einrichtung zur variablen Steuerung des Anteils an energiereichen Teilchen aus den einzelnen Strahlen in dem einheitlichen Strahl.

43. Vorrichtung nach einem der Ansprüche 36 bis 42, enthaltend eine Einrichtung zum Verschieben des Werkstücks in der Vakuumkammer, um Oberflächenbereiche des Werkstücks dem Auftreffen des Strahls oder der Strahlen nacheinander auszusetzen.

44. Vorrichtung nach einem der Ansprüche 36 bis 43, umfassend eine Einrichtung (12, 16, 62, 83) zum Impulsbetrieb mindestens eines der Strahlen mit vorgegebener zeitlicher Dauer, um eine Anhäufung aus den entsprechenden energiereichen Teilchen zu bilden, und zum Beschießen des Werkstücks mit den Teilchen in der Anhäufung.

45. Vorrichtung nach Anspruch 44, wobei die Impuls-Einrichtung Impulse bereitstellt, deren zeitliche Dauer zwischen 0,5 und 10 Mikrosekunden liegt, um die Anhäufung so zu bilden, daß die Anzahl der darin angesammelten energiereichen Teilchen zwischen 100 und 1000 liegt.

46. Vorrichtung nach Anspruch 44 oder 45, wobei die Impuls-Einrichtung mindestens einen der Strahlen impulsartig intermittierend erzeugt, um eine Folge von Anhäufungen der einzelnen energiereichen Teilchen zum aufeinanderfolgenden Auftreffen auf das Werkstück zu bilden.

47. Vorrichtung nach Anspruch 41 oder einem der davon anhängigen Ansprüche 42 bis 46, umfassend eine Einrichtung zum wiederholten impulsförmigen Erzeugen eines der Strahlen in dem einheitlichen Strahl.

48. Vorrichtung nach Anspruch 41 oder einem der davon abhängigen Ansprüche 42 bis 46, umfassend eine Steuereinrichtung zum impulsmäßigen Erzeugen der Strahlen mit ungleicher Phase, um abwechselnd eine erste Anhäufung der energiereichen Teilchen und eine zweite Anhäufung der energiereichen Teilchen zu erzeugen, die nacheinander auf das Werkstück auftreffen.

49. Vorrichtung nach einem der Ansprüche 36 bis 48, umfassend eine Einrichtung (13, 113) zum Zuführen einer ionisierte Teilchen ausziehenden Beschleunigungsspannung zwischen 500 Volts und 5 Kilovolt.

50. Vorrichtung nach einem der Ansprüche 36 bis 49, die als Einrichtung zur Erzeugung der neutralen Teilchen eine Einrichtung (30) umfaßt, die so angeordnet ist, daß sie bei Beaufschlagung einen Energiestrahl auf die Quelle von neutralen Teilchen auftreffen läßt, der aus dieser die neutralen Teilchen bildende Atome herausschlägt.

51. Vorrichtung nach einem der Ansprüche 36 bis 50, gekennzeichnet durch eine Vakuumpumpeinrichtung, die an jeden der eine Ionenquelle enthaltenden Behälter, den die Quelle von neutralen Teilchen enthaltenden Behälter und die Vakuumkammer angeschlossen ist und Arbeitskennwerte aufweist, die ausreichen, um diese Einrichtungen auf Drucken von $10^{-3}$ bis 10 Torr ($\approx$0,133 bis 1,333 Pa) bzw. $10^{-6}$ bis $10^{-2}$ Torr ($\cong$1,333×$10^{-4}$ bis 1,333 Pa) bzw. $10^{-6}$ bis $10^{-4}$ Torr ($\cong$1,333×$10^{-4}$ bis 1,333×$10^{-2}$ Pa) zu halten.

**Revendications**

1. Procédé de traitement d'une pièce (2) au moyen de particules énergétiques dans une chambre (1) mise sous vide dans lequel on prévoit une pluralité de sources (21, 27) de telles particules de différentes substances prédéterminées eton dispose ces sources dans des réceptacles séparés respectifs (23, 28) de telle façon que chacun de ces réceptacles soit en communication avec le vide régnant dans ladite chambre et soit ouvert en direction de la pièce, on forme des particules ionisées (ions) de l'une au moins des substances provenant de la source correspondante (21) dans le réceptacle respectif (23), on extrait les particules ionisées de ladite substance à partir du réceptacle (23) sous la forme d'un faisceau (7) de particules ionisées dirigées vers la pièce (2) et on excite électriquement les particules ionisées extraites du réceptacle (23) de manière que ces particules ionisées soient propulsées, dans le faisceau (7), vers la pièce qu'elles acquièrent une valeur prédéterminée d'énergie cinétique et qu'elles bombardent une aire superficielle sélectionnée de la pièce se trouvant dans la chambre sous vide, caractérisé en ce qu'on forme des particules neutres d'au moins une autre des substances à partir de la source correspondante, parmi les sources (27), dans son réceptacle (28), on crée un gradient de pression à la fois pour extraire les particules neutres de cette autre substance à partir du réceptacle (28), sous la forme d'un faisceau (8) de particules neutres dirigées en direction de la pièce (2), et pour exciter ces particules neutres de telle façon qu'elles soient projetées dans le faisceau (8), qu'elles acquièrent une valeur prédéterminée d'énergie cinétique et qu'elles bombardent l'aire superficielle sélectionnée de la pièce (2) conjointement avec les particules ionisées, ces particules ionisées et les particules neutres qui bombardent conjointement l'aire superficielle de la pièce, constituant les particules énergétiques.

2. Procédé de traitement d'une pièce (2) suivant la revendication 1 caractérisé en ce qu'il comprend les étapes consistant à former des particules ionisées d'autre substances différentes à partir des sources corredspondantes dans les réceptacles respectifs, à extraire ces particules ionisées des autres substances respectives respectivement à partir des réceptacles correspondants, sous la forme de faisceaux séparés respectifs additionnels de particules des substances différentes, ces faisceaux étant dirigés en direction de la pièce (2), et à exciter électriquement les particules ionisées provenant de chacun des réceptacles, indépendamment de celles provenant de l'autre réceptacle ou des autres réceptacles de telle façon que les particules ionisées des subtances différentes respectives additionnelles soient projetées dans les faisceaux séparés respectifs, qu'elles acquièrent des valeurs respectives prédéterminées d'énergie cinétique et qu'elles bombardent conjointement une aire superficielle sélectionnée de la pièce (2) dans la chambre sous vide (1).

3. Procédé suivant la revendication 1 ou 2 caractérisé en ce que le gradient de pression est crée en appliquant un vide aux particules neutres au moyen d'une pression de gaz qui est inférieure à celle régnant dans le réceptacle (28, 50) contenant la source (27, 55) de particules neutres, ce vide étant appliqué en un endroit intermédiaire entre la source et la surface de la pièce.

4. Procédé suivant l'une quelconque des revendications précédentes caractérisé en ce que les particules énergétiques dans l'un au moins des faisceaux (7, 8, 91—95) sont extraites continuellement du réceptacle correspondant afin de venir frapper d'une matière continue la pièce.

5. Procédé suivant l'une quelconque des revendications précédentes caractérisé en ce qu'il comprend en outre l'étape consistant à focaliser les faisceaux de manière à former un faisceau unitaire dans lequel·les particules énergétiques des différentes substances sont mélangées avant de venir frapper la pièce.

6. Procédé suivant la revendication 5 caractérisé en ce qu'il comprend en outre une étape consistant à commander la proportion des ions énergétiques par rapport aux particules neutres énergétiques dans le faisceau unitaire.

7. Procédé suivant l'une quelconque des revendications précédentes caractérisé en ce qu'il comprend en outre l'étape consistant à déplacer la pièce dans la chambre à vide de manière à soumettre des aires superficielles successives de cette pièce à l'impact du flux unitaire.

8. Procédé suivant l'une quelconque des revendications précédentes caractérisé en ce qu'il comprend en outre une étape consistant à pulser l'un au moins des faisceaux avec une durée prédéterminée de manière à former un paquet des particules énergétiques correspondantes et à bombarder la pièce au moyen des particules formant ce paquet.

9. Procédé suivant la revendication 8 caractérisé en ce que la durée est comprise entre 0,5 et 10 microsecondes pour former un paquet regroupant un nombre de particules énergétiques comprise entre 100 et 1 000.

10. Procédé suivant la revendication 8 caractérisé en ce que le faisceau pulsé est pulsé par intermittences pour former une succession de paquets des particules énergétiques individuelles, ces paquets étant destinés à venir frapper successivement la pièce.

11. Procédé suivant la revendication 10 caractérisé en ce qu'il comprend en outre une étape consistant à focaliser les faisceaux respectifs (7, 8) de particules ionisées et de particules neutres pour former un faisceau unitaire, en mélangeant ainsi ensemble les ions dans l'un des faisceau et les particules neutres du second faisceau, avant de venir frapper la pièce, et une étape consistant à pulser l'un des deux faisceaux d'une manière répétée avec ladite durée d'impulsion.

12. Procédé suivant la revendication 11 caractérisé en ce qu'il comprend en outre une étape consistant à commander le rapport entre la masse et la charge des particules énergétiques venant frapper la pièce, au moins en partie en commandant la durée des impulsions.

13. Procédé suivant la revendication 10 caractérisé en ce que deux faisceaux sont pulsés de manière à être déphasés l'un par rapport à l'autre, pour produire un premier paquet de particules énergétiques d'une première substance et un second paquet de particules énergétiques d'une seconde substance, d'une manière alternée, pour venir frapper alternativement la pièce.

14. Procédé suivant la revendication 13 caractérisé en ce que les particules énergétiques constituant les premier et second paquets sont respectivement des ions de première et seconde substances.

15. Procédé suivant la revendication 13 caractérisé en ce que les particules énergétiques dans le premier paquet sont constituées par des ions de la première substance et les particules énergétiques dans le second paquet sont des particules neutres de la seconde substance.

16. Procédé suivant la revendication 13 caractérisé en ce qu'il comprend en outre une étape consistant à commander les durées de la pulsation des deux faisceaux, respectivement, pour commander le rapport des nombres de particules énergétiques dans les premier et second paquets venant frapper la pièce, pendant une période de temps donnée.

17. Procédé suivant la revendication 16 caractérisé en ce que chacune desdites durées est comprise entre 0,5 et 10 microsecondes.

18. Procédé suivant la revendication 10 caractérisé en ce que les deux faisceaux sont pulsés périodiquement sensiblement en synchronisme l'un avec l'autre de manière à produire respectivement un premier paquet de particules énergétiques constituées par des ions d'une première substance et un second paquet de particules énergétiques constituées par des particules neutres d'une seconde substance, afin de venir frapper pratiquement en synchronisme, par ces paquets, la pièce.

19. Procédé suivant la revendication 18 caractérisé en ce qu'il comprend en outre une étape consistant à focaliser les deux faisceaux pour mélanger les ions énergétiques du premier paquet et les particules neutres du second paquet, et former ainsi un paquet composite unitaire avant qui celui-ci ne vienne frapper la pièce.

20. Procédé suivant la revendication 19 caractérisé en ce qu'il comprend en outre une étape consistant à commander le rapport entre le masse et la charge du paquet composite unitaire.

21. Procédé suivant la revendication 18 caractérisé en ce que les deux faisceaux sont pulsés avec une durée d'impulsion comprise entre 0,5 et 10 microsecondes.

22. Procédé suivant la revendication 8 ou 9 caractérisé en ce que les ions énergétiques dans un faisceau sont extraits du réceptacle en appliquant une tension d'accélération allant de 500 volts à 5 kilovolt, se présentant sous la forme d'impulsions périodiques ayant une durée d'impulsion allant de 0,5 à 10 microsecondes, pour former une succession de paquets d'ions destinés à venir frapper successivement la pièce, et en ce qu'il comprend en outre une étape consistant à commander l'énergie d'impact de chacun des paquets successifs venant frapper la pièce en commandant corrélativement la tension d'accélération.

23. Procédé suivant l'une quelconque des revendications précédentes caractérisé en ce que les particules neutres sont formées dans le réceptacle correspondant (28) en projetant sur la source correspondante (27), maintenue dans le réceptacle, un faisceau d'énergie de manière à extraire de celle-ci des atomes constituant les particules neutres.

24. Procédé suivant la revendication 23 caractérisé en ce que le gradient de pression qui amène les particules neutres à être extraites du réceptacle correspondant et à acquérir la valeur correspondante d'énergie cinétique, est créé en appliquant un vide à la chambre (1) en un endroit (9) intermédiaire entre la source de particules neutres et la pièce, de manière à produire une pression de gaz inférieure à celle régnant dans le réceptacle (28), et il comprend en outre une étape consistant à commander l'énergie cinétique des particules neutres en faisant varier la pression du gaz.

25. Procédé suivant l'une quelconque des revendications 23 et 24 caractérisé en ce qu'il comprend en outre une étape consistant à pulser périodiquement le faisceau de particules neutres en pulsant le faisceau d'énergie venant frapper la source correspondante (27).

26. Procédé suivant l'une quelconque des revendications précédentes caractérisé en ce que il comprend en outer une étape consistant à maintenir le réceptacle avec la source d'ions, le réceptacle avec la source de particules neutres et la chambre sous vide respectivement à des pressions de $10^{-3}$ à 10 Torr, $10^{-6}$ à $10^{-2}$ Torr et $10^{-6}$ à $10^{-4}$ Torr (0,1333 à 1333 Pa; $1,333 \times 10^{-4}$ à 1,333 Pa, et $1,333 \times 10^{-4}$ à $1,333 \times 10^{-2}$ Pa).

27. Procédé suivant la revendication 4 caractérisé en ce que le faisceau extrait et frappant la pièce d'une manière continue est un faisceaux de particules neutres, et on forme, on extrait, on dirige et on excite des particules de différentes substances afin de former une pluralité de faisceaux de particules énergétiques constituées par des ions de différentes substances, afin de bombarder conjointement l'aire superficielle au moyen de ces faisceaux.

28. Procédé suivant la revendication 27 caractérisé en ce qu'il comprend en outre une étape consistant à produire successivement les faisceaux de particules énergétiques de substances différentes afin de bombarder successivement, au moyen de ces faisceaux, la pièce.

29. Procédé suivant la revendication 28 caractérisé en ce que les énergies d'impact des particules énergétiques venant frapper successivement la pièce, dans les faisceaux produits successivement, sont établies à des valeurs respectives prédéterminées.

30. Procédé suivant la revendication 29 caractérisé en ce qu'il comprend en outre une étape consistant à maintenir chacun des faisceaux, produits successivement, de particules énergétiques venant frapper la pièce pendant une période de temps prédéterminée en fonction d'une modification cristal lographique prédéterminée désirée dans la zone superficielle bombardée de la pièce.

31. Procédé suivant l'une quelconque des revendications 28 à 30 caractérisé en ce que les différents faisceaux sont produits successivement en formant successivement les particules de différentes substances à partir des sources correspondantes dans les réceptacles respectifs.

32. Procédé suivant l'une quelconque des revendications 28 à 30 caractérisé en ce que les faisceaux différents sont produits successivement en extrayant successivement et en excitant les particules formées dans les réceptacles respectifs.

33. Procédé suivant l'une quelconque des revendications 28 à 32 caractérisé en ce que la pièce est bombardée au moyen des particules énergétiques constituées par des ions de différentes substances, afin de déposer successivement ces substances sur la pièce.

34. Procédé suivant la revendication 27 caractérisé en ce qu'il comprend en outre une étape consistant à focaliser les faisceaux d'ions énergétiques des différentes substances avant qu'il ne viennent frapper la pièce, afin de former un faisceau composite d'ions mélangés conjointement en vue du dépôt sur la pièce.

35. Procédé suivant la revendication 27 caractérisé en ce qu'il comprend en outre une étape consistant à focaliser les faisceaux d'ions énergétiques de substances différentes avant leur arrivée sur la pièce afin de former un faisceau composite d'ions mélangés ensemble en vue d'une diffusion cinétique vers et dans la pièce.

36. Appareil pour traiter une pièce (2) au moyen de particules énergétiques de dimension atomique ou moléculaire par un procédé suivant l'une quelconque des revendications 1 à 35, comprenant une chambre à vide (1), un support (3) pour maintenir la pièce dans la chambre à vide (1), une pluralité de sources (21, 27) de particules de substances différentes prédéterminés, chaque source étant maintenue dans un réceptacle séparé (23, 28) communiquant avec le vide de la chambre (1) et s'ouvrant vers la pièce (2), au moins un générateur (5, 22, 25, 26) de particules ionisées (ions), associé respectivement à une source sélectionnée parmi les diverses sources (21), dans un réceptacle correspondant (23), et un dispositif d'alimentation électrique (10, 12, 13) qui est connecté de manière à produire un champ électrique, entre le réceptacle (23) et le support (3), ayant une configuration telle qu'il assure l'extraction, à partir du réceptacle, des particules ionisées sous la forme d'un faisceau (7) dirigé vers la pièce (2) et d'une amplitude telle qu'il excite électriquement ces particules ionisées et qu'il les propulse dans le faisceau, avec une valeur prédéterminée d'énergie cinétique, en direction d'une aire superficielle sélectionné de la pièce (2), caractérisé en ce qu'il comprend au moins un générateur de particules neutres (6, 27, 30, 32) associé à une autre source sélectionnée (27) parmi les sources, et une source de gradient de pression (9) associé à ce réceptacle, cette source (9) ayant une configuration telle qu'elle assure l'extraction des particules neutres, à partir du réceptacle, sous la forme d'un faisceau (8) dirigé vers la pièce, et ayant une grandeur telle qu'elle excite les particules neutres de manière à les projeter, dans le faisceau (8), avec une valeur prédéterminée d'énergie cinétique, en direction de la pièce (2).

37. Appareil suivant la revendication 36 caractérisé en ce qu'il comprend d'autres générateurs de particules ionisées (ions) associés respectivement aux sources se trouvant dans les réceptacles correspondants, et une pluralité de dispositifs d'alimentation électrique additionnels associés respectivement aux réceptacles, ces dispositifs d'alimentation électrique additionnels ayant des configurations telles qu'ils assurent l'extraction des particules ionisées des substances différentes respectivement sous la forme de faisceaux de particules respectifs dirigés vers la pièce (2) et ayant une amplitude telle qu'elle assure l'excitation électrique des particules ionisées dans les faisceaux respectifs, afin de les projeter, avec des valeurs prédéterminées respectives d'énergie cinétique, vers la pièce, afin de réaliser un bombardement conjoint d'une aire superficielle sélectionnée de la pièce au moyen de ces faisceaux.

38. Appareil suivant l'une quelconque des revendications 36 ou 37 caractérisé en ce que la source de gradient de pression (9) comprend une pompe à vide (9) mise en place, afin de créér un vide dans la chambre (1), en un emplacement intermédiaire entre la pièce (2) et la source de particules neutres, le vide ainsi produit ayant une amplitude telle que la pression du gaz à l'endroit de la pièce (2) soit inférieure à celle régnant à l'endroit du réceptacle (28, 50) dans lequel les particules neutres sont formées et ayant une amplitude suffisante pour entraîner et accélérer les particules neutres dans le faisceau.

39. Appareil suivant l'une quelconque des revendications 36 à 38 caractérisé en ce que le dispositif d'alimentation électrique ou chaque dispositif d'alimentation électrique comporte au moins une source de tension (13, 113), cette source de tension ayant une amplitude et une configuration telle qu'elle applique un potentiel d'accélération aux ions formés par le générateur d'ions associé, afin d'amener ces ions à être propulsés avec ladite valeur prédéterminée d'énergie cinétique et à venir frapper la pièce.

40. Appareil suivant l'une quelconque des revendications 36 à 39 caractérisé en ce qu'il comprend en outre des moyens de commutation (12, 16, 83) pour pulser le faisceau d'ions ou chaque faisceau afin de former un paquet de d'ions.

41. Appareil suivant l'une quelconque des revendications 36 à 40 caractérisé en ce qu'il comporte des moyens (17—19) pour focaliser les faisceaux, ces moyens ayant une configuration telle qu'ils forment un faisceau unitaire dans lequel les particules énergétiques des différentes substances sont mélangées avant de venir frapper la pièce.

42. Appareil suivant la revendication 41 caractérisé en ce qu'il comporte des moyens de commande variables pour commander la proportion, dans le faisceau unitaire, des particules énergétiques provenant des faisceaux individuels.

43. Appareil suivant l'une quelconque des revendications 36 à 42 caractérisé en ce qu'il comporte des moyens pour déplacer la pièce dans la chambre à vide, afin de soumettre des aires superficielles successives de cette pièce à l'impact des faisceaux.

44. Appareil suivant l'une quelconque des revendications 36 à 43 caractérisé en ce qu'il comporte des moyens (12, 16, 62, 83) pour pulser l'un au moins des faisceaux avec une durée prédéterminée, afin de former un paquet de particules énergétiques correspondantes et de bombarder la pièce avec les particules du paquet.

45. Appareil suivant la revendication 44 caractérisé en ce que les moyens de pulsation fournissent des impulsions dont la durée est comprise entre 0,5 et 10 microsecondes, afin de former un paquet dans lequel les particules énergétiques regroupées sont au nombre de 100 à 1 000.

46. Appareil suivant l'une quelconque des revendications 44 ou 45 caractérisé en ce que les moyens de pulsation pulsent l'un au moins des faisceaux d'une manière intermittente de manière à former une succession de paquets de particules énergétiques individuelles, afin de venir frapper successivement la pièce au moyen de ces paquets.

47. Appareil suivant la revendication 41 ou l'une quelconque des revendications 42 à 46 qui s'y rattachent caractérisé en ce qu'il comporte des moyens pour pulser d'une manière répétée l'un des faisceaux dans le faisceau unitaire.

48. Appareil suivant la revendication 41 ou l'une quelconque des revendications 42 à 46 qui s'y rattachent caractérisé en ce qu'il comprend des moyens de commande pour pulser les faisceaux en les déphasant de manière produire alternativement un premier paquet de particules énergétiques et un second paquet de particules énergétiques, pour que ces paquets viennent frapper alternativement la pièce.

49. Appareil suivant l'une quelconque des revendications 36 à 48 caractérisé en ce qu'il comporte des moyens (13, 113) pour fournir une tension d'accélération assurant l'extraction des particules ionisées comprise entre 500 volts et 5 kilovolts.

50. Appareil suivant l'une quelconque des revendications 36 à 49 caractérisé en ce qu'il comporte, en tant que générateur de particules neutres, un moyen (30) placé de telle façon que, lorsqu'il est excité, il projette un faisceau d'énergie sur la source de particules neutres afin d'extraire de celle-ci des atomes constituant les particules neutres.

51. Appareil suivant l'une quelconque des revendications 36 à 50 caractérisé en ce qu'il comporte des moyens de pompage pour créér un vide, lesquels sont associés à chaque réceptacle contenant une source d'ions, au réceptacle contenant une source de particules neutres et à la chambre sous vide, ces moyens ayant des caractéristiques de fonctionnement suffisantes pour les maintenir respectivement à des pressions de $10^{-3}$ à 10 Torr, $10^{-6}$ à $10^{-2}$ Torr et $10^{-6}$ à $10^{-4}$ Torr (0,1333 à 1,333 Pa; $1,333\times10^{-4}$ à 1,333 Pa, et $1,333\times10^{-4}$ à $1,333\times10^{-2}$ Pa).

# FIG. 1

FIG. 2

0 061 906

# FIG. 3

# FIG. 4